# EUROPEAN PATENT APPLICATION

(11) **EP 2 306 488 A1**
(43) Date of publication of application: **06.04.2011**
(21) Application number: 10180503.4
(22) Date of filing: 28.09.2010
(51) Int. Cl.: H01J 5/62, H05K 3/20, H05K 3/40

(54) **Vehicular discharge lamp**

(30) Priority: 02.10.2009 JP 2009230278
(71) Applicant: Koito Manufacturing Co., Ltd., Tokyo 108-8711 (JP)
(72) Inventor: Miyagishima, Kaname, Shizuoka-shi Shizuoka (JP); Fujimura, Hiroki, Shizuoka-shi Shizuoka (JP); Ishibashi, Hiroki, Shizuoka-shi Shizuoka (JP)
(74) Representative: Grünecker, Kinkeldey, Stockmair & Schwanhäusser Anwaltssozietät

(57) **Abstract**

A vehicular discharge lamp (1) including a discharge lamp bulb (2) and a bulb base to which the discharge lamp bulb (2) is attached, wherein the bulb base has a circuit portion (5). A conductive bus bar comprises at least one terminal of a connector portion integrally formed with a corresponding main body bus bar provided with a lead terminal. The conductive bus bar is entirely covered with an insulation member, excluding a portion for connection with the lead terminal of the component.

## Description

The present invention relates to art for a vehicular discharge lamp according to the preamble of independent claim 1. Such a vehicular discharge lamp can be taken from JP 2005-71997 A.

A vehicular discharge lamp described in JP 2005-71997 A is known as a conventional vehicular discharge lamp. The vehicular discharge lamp of JP 2005-71997 A is configured such that the position of a structural unit (discharge bulb) is fixed with respect to a lamp socket. The lamp socket has a socket outer part and a cover. Inside the socket outer part, two chambers divided by a partition wall are provided, and one of the chambers contains a starting circuit of the discharge lamp bulb. The starting circuit is formed from a mount board having the same shape as a transverse cross section of the chamber accommodating the starting circuit, and a female power supply connector.

Contact pins (terminals) of the female power supply connector are joined to conductor paths (not shown) of the mount board by soldering, welding, or the like, so that the female connector is mounted on the mount board.

The starting circuit shown in FIG. 3 of JP 2005-71997 A is configured such that the female power supply connector and the mount board are formed as separate members and the plurality of contact pins (terminals) of the power supply connector and the conductor paths (not shown) of the mount board are joined by soldering or the like. Therefore, a plurality of contact portions of the terminals is exposed, projecting from a surface of the mount board. Thus, the starting circuit of Patent Document 1 has a low insulation performance.

The terminals (joined portions) of the power supply connector exposed in a projecting manner may cause current leakage (a discharge phenomenon) between adjacent terminals or electronic components. Therefore, the plurality of connector terminals adjacent to each other on a substrate of the starting circuit must be disposed such that there is a large distance between the terminals. The electronic components mounted on the starting circuit must be disposed spaced apart from the exposed terminals (joined portions) of the power supply connector. Such a layout causes a problem of an increase in the size of the starting circuit, which leads to an increase in the size of the vehicular discharge lamp.

It is an object of the present invention to provide a vehicular discharge lamp as indicated above having improved insulation performance of a starting circuit.

According to the present invention said object is solved by vehicular discharge lamp having the features of independent claim 1. Preferred embodiments are laid down in the dependent claims. Accordingly, it is provided a vehicular discharge lamp that enhances insulation properties of a circuit to downsize a starting circuit.

When there is a plurality of exposed portions projecting from the circuit portion as described in JP 2005-71997 A, current leakage (a discharge phenomenon) occurs depending on the distance between the exposed terminals and an applied voltage. Therefore, the terminals must be disposed, spaced apart from each other. However, in the present invention, only a required minimum lead wire connection terminal portion is exposed inside the insulation member, and the exposed portion projecting from the circuit portion is eliminated. As a result, the insulation performance of the circuit portion improves. Thus, even if the distances between a plurality of terminals of the circuit portion are shortened or electronic components are disposed near the terminal of the connector portion, current leakage (a discharge phenomenon) does not occur. In other words, in the circuit portion, it is possible to shorten distances between a plurality of connector terminals and to dispose an electronic component near the connector portion. Thus, it is possible to downsize the circuit portion.

Note that, in the production of the circuit portion, elimination of the joined portion between the terminal of the connector portion and the bus bar enables a reduction of a soldering or welding process for the joined portion, which can also achieve a reduction in processing man-hours. In addition, extra space is freed up because it is not necessary to provide the circuit portion with space for welding. Moreover, even if the terminals are close to each other, leakage does not occur because of the covering. Therefore, it is possible to increase the plate thickness or plate width to improve the electrical efficiency of each terminal.

Hereinafter, the present invention is illustrated and explained by means of preferred embodiment in conjunction with the accompanying drawings. In the drawings wherein:
- FIG. 1: is an exploded perspective view of a vehicular discharge lamp according to a first embodiment.
- FIG. 2: is a perspective view of a circuit portion of the vehicular discharge lamp.
- FIG. 3: is a perspective view of a connector terminal integration-type conductive bus bar of the circuit portion.
- FIG. 4: is a perspective view showing the bus bar integrated with a resin material.
- FIG. 5: is a perspective view showing the circuit portion attached to a case of a bulb socket.
- FIG. 6(a): is a perspective view showing a cover attached to the case of FIG. 5. FIG. 6(b)is a frontal view of the bulb socket showing a drain hole of the case.
- FIG. 7: is a reference perspective view regarding the drainage of water inside the case of the bulb socket.
- FIG. 8: is a perspective view of a second embodiment of the vehicular discharge lamp that includes a structure for preventing improper attachment of a cover.
- FIG. 9: is a perspective view showing the cover of FIG. 8 attached to the case of the bulb socket.

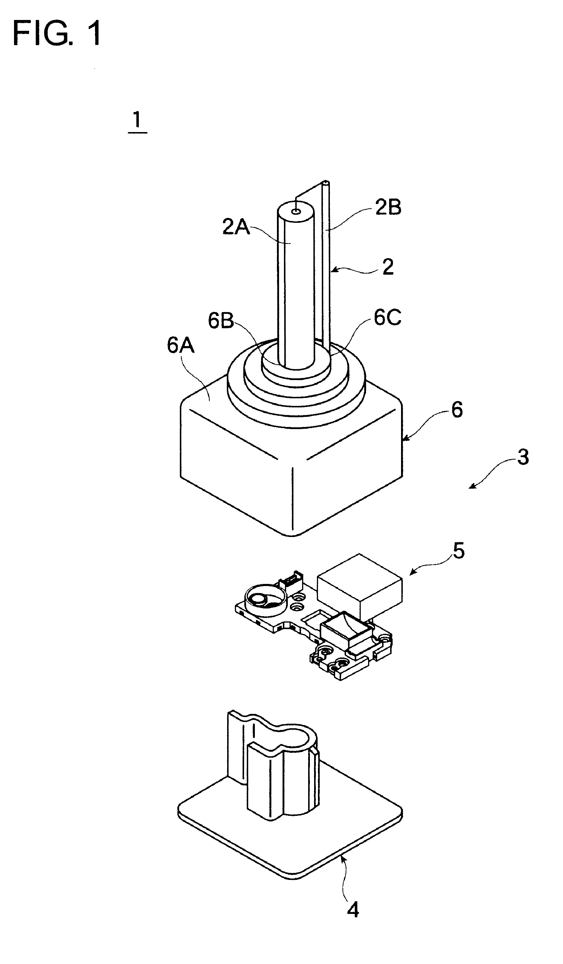

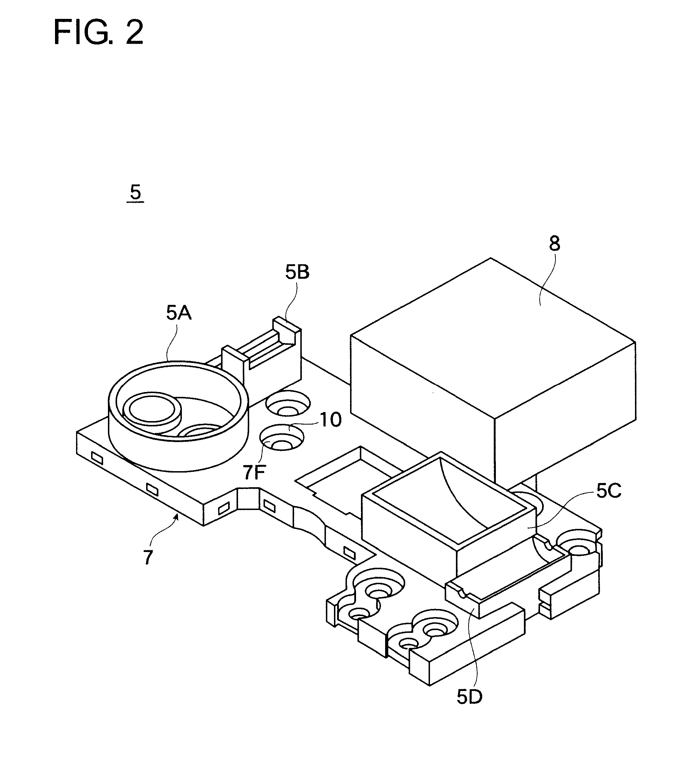

Next, preferred embodiments will be described based on FIGS. 1 to 9.

FIGS. 1 to 7 show a first embodiment of a vehicular discharge lamp. A vehicular discharge lamp 1 according to the first embodiment includes a discharge lamp bulb 2, a bulb socket 3, and a cover 4.

The discharge lamp bulb 2 has a glass tube 2A that accommodates an arc tube (not shown) provided with a pair of electrodes therein; and a power supply lead wire 2B. Respective one ends of the pair of electrodes are provided facing each other inside the sealed arc tube. Another end of one of the electrodes projects from a lower end portion of the glass tube 2A (although not shown in the drawings), and another end of the other of the electrodes is connected to the lead wire 2B.

The bulb socket 3 has a circuit portion 5 and a case 6. The case 6 includes a bulb attachment hole 6B penetrating to an upper end portion 6A, and a lead wire through hole 6C. The case 6 has a box shape whose lower end portion is open. Inside the case 6, an accommodation portion 6D for accommodating the circuit portion 5 is provided. The discharge lamp bulb 2 is fixed to the case 6 by bonding or the like, with the lower end portion of the glass tube 2A inserted into the attachment hole 6B and one end of the lead wire 2B inserted into the lead wire through hole 6C. As a result, the one end of the one of the electrodes that projects from the lower end portion of the glass tube 2A and one end of the lead wire 2B connected to the other of the electrodes are each disposed inside the accommodation portion 6D of the circuit portion 5. The one end of the electrode and the one end of the lead wire 2B projecting inside the accommodation portion 6D are respectively connected to predetermined lead wire connection portions of main body bus bars (7A to 7E) described later. Note that the discharge lamp bulb 2 may be detachably attached to the attachment hole 6B of the bulb socket 3.

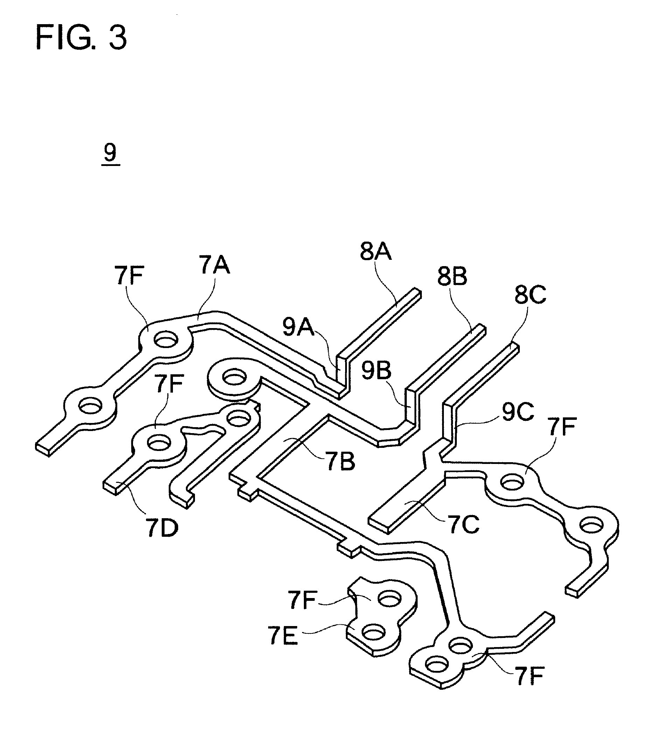

The circuit portion 5 is a starting circuit, which is a part of a lighting circuit of the discharge lamp bulb 2. The circuit portion 5 is configured with a circuit portion main body 7 mounted with electronic components (5A to 5D), and a female power supply connector portion 8. The circuit portion main body 7 and the female power supply connector portion 8 are formed by integrating through insert molding a conductive bus bar 9 of FIG. 3 with a resin member 10 serving as an insulation member. The conductive bus bar 9 is configured with terminals (8A to 8C) of the connector portion 8 and the main body bus bars (7A to 7E) serving as conductive paths of the circuit portion main body 7. The terminals (8A to 8C) of the connector portion 8 are each integrally formed with a corresponding part (7A to 7C) of the main body bus bars from one metal plate member or the like through punching, bending, or the like. As a result, in the first embodiment, the terminals (8A to 8C) are integrally formed with the main body bus bars (7A to 7C) via bent portions (9A to 9C). Moreover, the main body bus bars (7A to 7E) are formed with a plurality of ring-shaped lead wire connection portions 7F, to which lead terminals of the electronic components (5A to 5D), the lead terminal of the discharge lamp bulb 2, and the one end of the lead wire 2B are connected.

The entire conductive bus bar 9 is inserted into the resin material 10, after the main body bus bars (7A to 7C) are integrally formed with the terminals (8A to 8C) of the connector portion 8. The resin thickness of the resin material 10 is preferably at least 0.5 mm from the standpoint of securing the insulation performance of the circuit portion. In addition, the resin material 10 is provided with holes 10A at positions corresponding to the lead wire connection portions 7F, so that the ring-shaped lead wire connection portions 7F are exposed inside the resin material 10. The terminals of the electronic components (5A to 5D), the terminal of the discharge lamp bulb 2, and the one end of the lead wire 2B are each inserted into the hole of the corresponding lead wire connection portion 7F and coupled to the connection portion 7F through welding or the like.

As a result, in the conductive bus bar 9, relay portions (portions corresponding to the bent portions 9A to 9C) between the main body bus bars (7A to 7C) and the terminals (8A to 8C) of the connector portion 8 are not exposed in a projecting manner. Thus, a problem of current leakage is prevented.

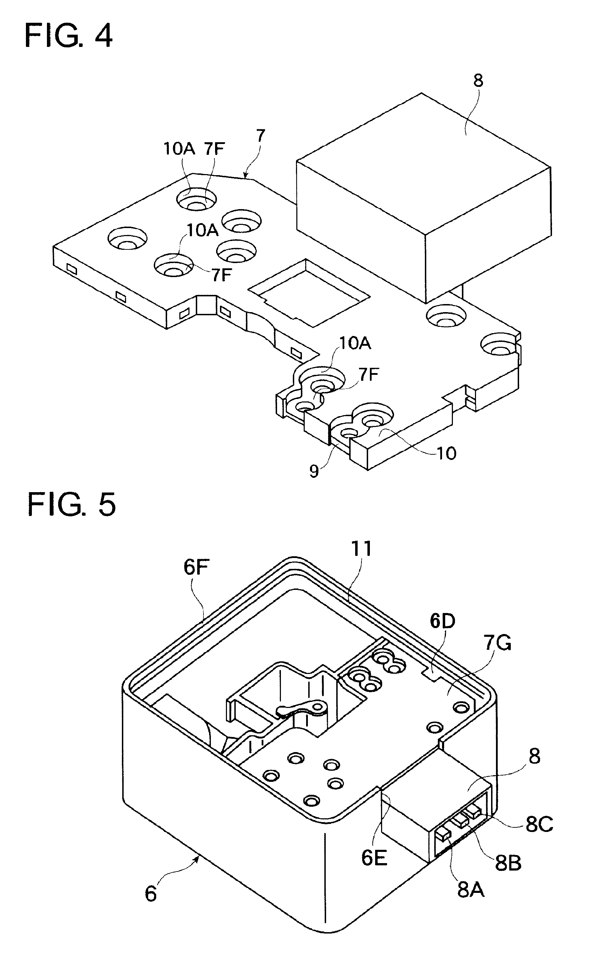

Further, the circuit portion 5 mounted with the electronic components is accommodated and fixed in the accommodation portion 6D of the case 6 from the backside of the case 6, with the electronic components (5A to 5D) facing down, as shown in FIG. 5. The circuit portion main body 7 is accommodated in the accommodation portion 6D, while the female power supply connector portion 8 is engaged with a slit-shaped connector engagement portion 6E that is provided in the outer perimeter side surface of the case 6 so as to project outside the case 6.

A lower end opening portion 6F of the case 6 is hidden by attaching the cover 4. An inner perimeter of the accommodation portion 6D of the case 6 is provided with a stepped portion 11 for holding the cover 4 in the vicinity of the lower end opening portion 6F. The stepped portion 11 is provided at a position spaced apart from a back surface 7G of the accommodated circuit portion main body 7. As a result, the cover 4 is held by the stepped portion 11 while spaced apart from the back surface 7G of the circuit portion main body 7. Thus, the cover 4 is attached to the lower end opening portion 6F.

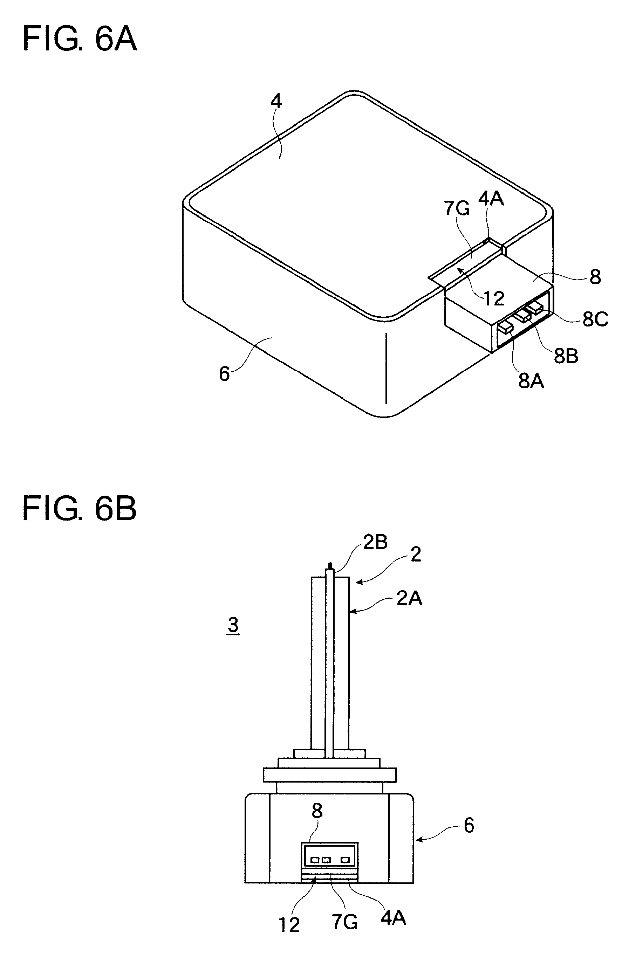

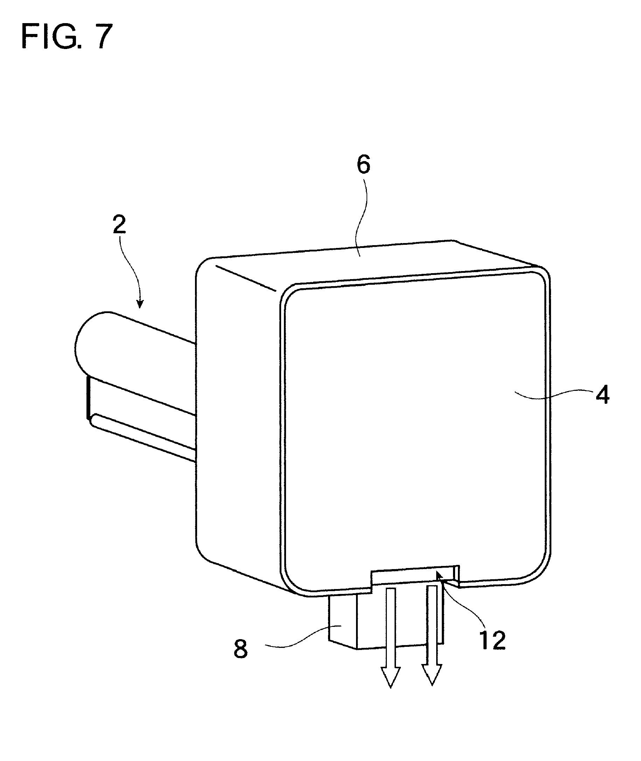

Moreover, the cover 4 is provided with a recess 4A at a position corresponding to the female connector portion 8. Furthermore, defined between the recess 4A of the cover 4 and the connector engagement portion 6E of the case 6 is a drain hole 12 that penetrates from the accommodation portion 6D to the outside of the case 6 via a gap between the cover 4 and the back surface 7G of the circuit portion main body 7, as shown in FIG. 6. According to the preferred embodiment, the relay portions (bent portions 9A to 9C) between the main body bus bars (7A to 7C) and the terminals (8A to 8C) of the connector portion 8 are not exposed. Therefore, when water droplets occur in the accommodation portion 6D for the circuit portion 5 due to condensation, it is possible to drain the water droplets by putting the connector portion 8 face down, as shown in FIG. 7. Thus, troubles such as short-circuiting of the circuit portion 5 due to water droplets occurring inside the accommodation portion 6D are prevented.

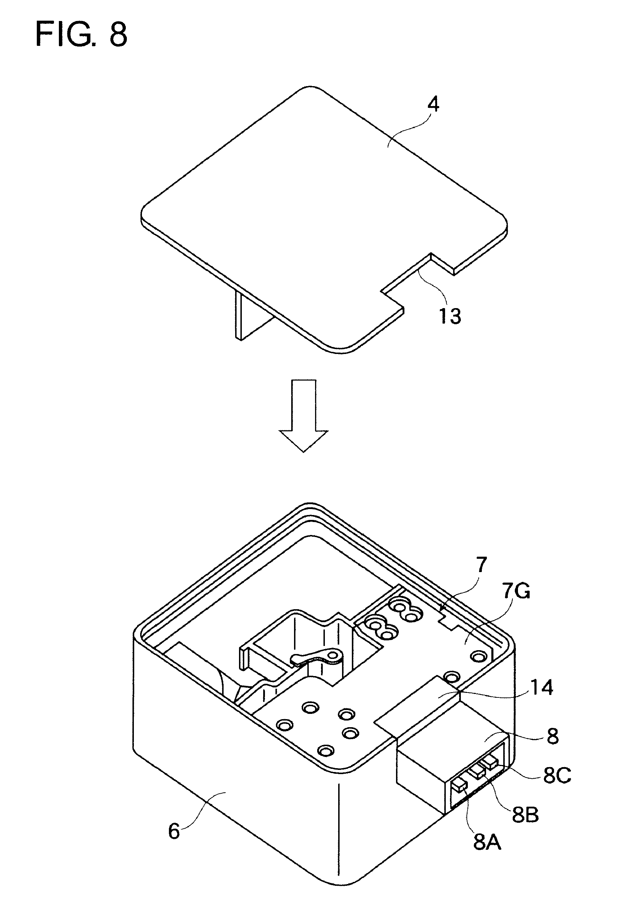

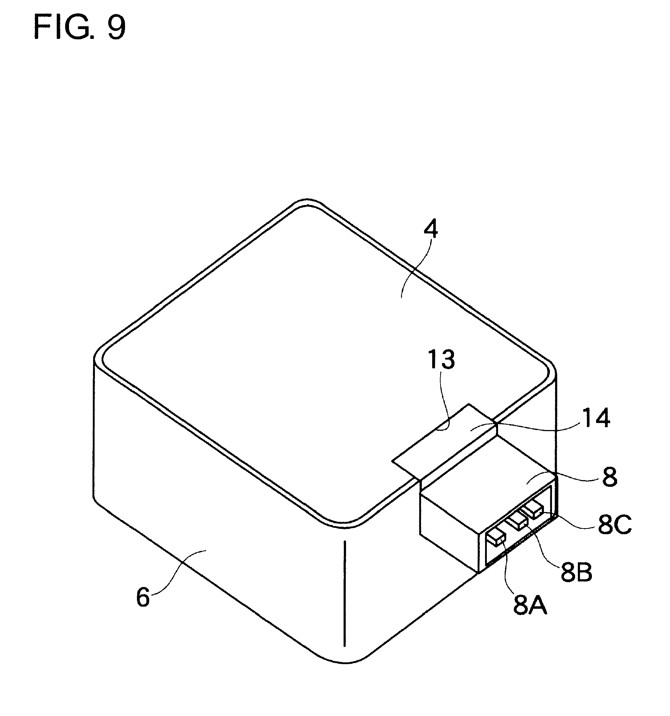

Next, a second embodiment will be described, based on FIGS. 8 and 9. The second embodiment is provided with means for preventing improper attachment when attaching the cover 4 to the case 6, in place of the drain hole 12 of the first embodiment. Specifically, the cover 4 is provided with a recess portion 13 that is not for drainage but for positioning. The back surface 7G of the circuit portion main body 7, which is accommodated and fixed in the accommodation chamber 6D inside the case 6, is provided with a protruding portion 14 that is to be engaged with the recess portion 13 for positioning, such that the protruding portion 14 protrudes from the back surface 7G toward the cover 4 (in this case, the drain hole is defined at another location). Other configurations of the second embodiment are in common with the first embodiment. By engaging the recess portion 13 of the cover 4 with the protruding portion 14 of the circuit portion main body, the cover 4 can be attached to the lower end portion of the case without risk of mistaking the direction of attachment.
According to the preferred embodiments, it is provided a vehicular discharge lamp that is downsized by improving the insulation performance of a starting circuit of a discharge lamp bulb. The vehicular discharge lamp 1 includes a discharge lamp bulb 2, and a bulb socket 3 to which the discharge lamp bulb 2 is attached. The bulb socket 3 has a circuit portion 5 equipped with a power supply connector portion 8, and a case 6 that accommodates therein the circuit portion 5 and is attached with the discharge lamp bulb. In the vehicular discharge lamp 1, terminals (8A to 8C) of the connector portion 8 and corresponding conductive bus bars (7A to 7C) of a main body 7 of the circuit portion 5 are integrally formed from one material, and an integrally formed conductive bus bar 9 is entirely covered with an insulation member 10, excluding lead terminal connection portions 7F of an electronic component. With the vehicular discharge lamp including a discharge lamp bulb 2 and a bulb socket 3 to which the discharge lamp bulb 2 is attached, wherein the bulb socket 3 has a circuit portion 5 that is equipped with a power supply connector portion 8 and is connected to a lead terminal 7F of an electronic component, and a case 6 that accommodates therein the circuit portion 5 and is attached with the discharge lamp bulb 2, a terminal 8A to 8C of the connector portion 8 and a conductive bus bar 9 corresponding to a main body of the circuit portion 5 are integrally formed, and the integrally formed conductive bus bar 9 is entirely covered with an insulation member 10, excluding a portion for connection with the lead terminal 7F of the electronic component, it is possible to downsize the vehicular discharge lamp by downsizing the circuit portion based on improved insulation properties of the circuit portion. In addition, it is possible to reduce the production time and cost, and improve the electrical efficiency of the circuit portion.
In the vehicular discharge lamp, a terminal of the connector portion and a conductive bus bar corresponding to a main body of the circuit portion are integrally formed from one material (e.g., one plate material) through punching, bending, or the like. The conductive bus bar including the terminal is entirely covered with an insulation member, except a portion for connection with the lead terminal of the electronic component.

(Operation) The terminal of the connector portion and the bus bar of main body of the circuit portion are integrally formed from one material. Thus, there is no joined portion between the terminal of the connector portion and the bus bar. Moreover, the conductive bus bar including the terminal of the connector portion and the bus bar of the circuit portion main body that are integrally formed is entirely covered with the insulation material, excluding the portion for connection with the lead terminal of the electronic component. Therefore, the circuit portion has no terminal portion that is exposed projecting from a surface of the circuit portion.

With the vehicular discharge lamp according an preferred embodiment, wherein a cover 4 is attached to a lower end portion of the case 6 accommodating the circuit portion 5, and a drain hole 12 is defined between the cover 4 and the case 6 in the vicinity of the connector portion 8, it is possible to drain water inside the case of the bulb socket. Therefore, short-circuiting or condensation in the circuit portion caused by accumulation of water droplets inside the case can be prevented.

(Operation) The connector terminal is covered with the insulation member and is not exposed. Therefore, even when a through hole communicating the inside and the outside of the case is defined between the case and the cover of the bulb socket in the vicinity of the connector portion, leakage (a discharge phenomenon) via the through hole does not occur between the terminal of the connector portion and a metal case outside the bulb socket case. As a result, it is possible to drain water inside the case of the bulb socket.
With the vehicular discharge lamp according an preferred embodiment, wherein cover 4 is attached to a lower end portion 6F of the case 6 accommodating the circuit portion 5, a recess portion 13 is provided on the cover 4, and a protruding portion 14 for positioning that is engaged with the recess portion 13 is provided in the vicinity of the connector portion 8 of the circuit portion 5, improper attachment of the cover to the case of the bulb socket can be prevented.

(Operation) In the circuit portion, by eliminating the joined portion between the terminal of the connector portion and the bus bar, the freedom of design increases. Therefore, it is possible to provide the circuit portion with the protruding portion in the vicinity of the connector portion. As a result, the cover can be attached in a proper orientation with respect to the case, by attaching to the case of the bulb socket while engaging the recess portion provided in the cover with the protruding portion in the vicinity of the connector portion of the circuit portion.

According to the preferred embodiments it is provided a vehicular discharge lamp including a discharge lamp bulb 2 and a bulb socket 3 to which the discharge lamp bulb 2 is attached, wherein the bulb socket 3 has a circuit portion 5 that is equipped with a power supply connector portion 8 having at least one terminal 8A to 8C connected to a lead terminal 7F of a component 5A to 5D, 2A, 2B. A conductive bus bar 9 comprises said terminal 8A to 8C of the connector portion 8 integrally formed with a corresponding main body bus bar 7A to 7E provided with said lead terminal 7F, and the conductive bus bar 9 is entirely covered with an insulation member 10, excluding a portion for connection with the lead terminal 7F of the component 5A to 5D, 2A, 2B.

Said power supply connector portion 8 comprises a plurality of terminals 8A to 8C, each being integrally formed with a corresponding main body bus bar 7A to 7E of a circuit portion main body 7. The main body bus bars 7A to 7E are provided with lead terminals 7F exposed from the insulation member 10. Said main body bus bars 7A to 7E of the circuit portion main body 7 are formed with a plurality of lead terminals 7F, which connects terminals of electronic components 5A to 5D, a lead terminal of the discharge bulb 2 and a power supply lead wire 2B of the discharge bulb 2. A bent portion 9A to 9C is integrally connecting the terminal 8A to 8C of the connector portion 8 with the corresponding main body bus bar 7A to 7E. The insulation member 10 is made of resin by insert molding. Said lead terminal 7F is ring shaped.

The bulb socket 3 has a case 6 that accommodates therein the circuit portion 5. Said case 6 is provided with a bulb attachment hole 6B and a lead wire through hole both penetrating and end portion 6A of the case 6.

According to a specific embodiment a cover 4 is attached to a lower end portion of the case 6 accommodating the circuit portion 5, and a drain hole 12 is defined between the cover 4 and the case 6 in the vicinity of the connector portion 8.

According to a further specific embodiment a cover 4 is attached to a lower end portion 6F of the case 6 accommodating the circuit portion 5, a recess portion 13 is provided on the cover 4, and a protruding portion 14 for positioning that is engaged with the recess portion 13 is provided in the vicinity of the connector portion 8 of the circuit portion 5.

### Description of the Reference Numerals

- 1: VEHICULAR DISCHARGE LAMP
- 2: DISCHARGE LAMP BULB
- 3: BULB SOCKET
- 4: COVER
- 5: CIRCUIT PORTION
- 6: CASE
- 6F: LOWER END OPENING PORTION
- 7: CIRCUIT PORTION MAIN BODY
- 7A TO 7C: MAIN BODY BUS BARS CORRESPONDING TO TERMINALS
- 7F: LEAD TERMINAL CONNECTION PORTION OF ELECTRONIC COMPONENT
- 8: POWER SUPPLY CONNECTOR PORTION
- 8A TO 8C: TERMINALS OF CONNECTOR PORTION
- 9: CONDUCTIVE BUS BAR
- 10: RESIN MEMBER (INSULATION MEMBER)
- 12: DRAIN HOLE
- 13: RECESS PORTION FOR COVER POSITIONING
- 14: PROTRUDING PORTION FOR CIRCUIT PORTION SIDE POSITIONING

## Claims

1. A vehicular discharge lamp including a discharge lamp bulb (2) and a bulb socket (3) to which the discharge lamp bulb (2) is attached, wherein
the bulb socket (3) has a circuit portion (5) that is equipped with a power supply connector portion (8) having at least one terminal (8A to 8C) connected to a lead terminal (7F) of a component (5A to 5D, 2A, 2B),
**characterized in that**
a conductive bus bar (9) comprises said terminal (8A to 8C) of the connector portion (8) integrally formed with a corresponding main body bus bar (7A to 7E) provided with said lead terminal (7F), and
the conductive bus bar (9) is entirely covered with an insulation member (10), excluding a portion for connection with the lead terminal (7F) of the component (5A to 5D, 2A, 2B).

2. A vehicular discharge lamp according to claim 1, **characterized in that** said power supply connector portion (8) comprises a plurality of terminals (8A to 8C), each being integrally formed with a corresponding main body bus bar (7A to 7E) of a circuit portion main body (7), wherein the main body bus bars (7A to 7E) are provided with lead terminals (7F) exposed from the insulation member (10).

3. A vehicular discharge lamp according to claim 2, **characterized in that** said main body bus bars (7A to 7E) of the circuit portion main body (7) are formed with a plurality of lead terminals (7F), which connects terminals of electronic components (5A to 5D), a lead terminal of the discharge bulb (2) and a power supply lead wire (2B) of the discharge bulb (2).

4. A vehicular discharge lamp according to at least one of the claims 1 to 3, **characterized in that** a bent portion (9A to 9C) is integrally connecting the terminal (8A to 8C) of the connector portion (8) with the corresponding main body bus bar (7A to 7E).

5. A vehicular discharge lamp according to at least one of the claims 1 to 4, **characterized in that** the insulation member (10) is made of resin by insert molding.

6. A vehicular discharge lamp according to at least one of the claims 1 to 5, **characterized in that** said lead terminal (7F) is ring shaped.

7. A vehicular discharge lamp according to at least one of the claims 1 to 6, **characterized in that** the bulb socket (3) has a case (6) that accommodates therein the circuit portion (5).

8. A vehicular discharge lamp according to claim 7, **characterized in that** said case (6) is provided with a bulb attachment hole (6B) and a lead wire through hole both penetrating and end portion (6A) of the case (6).

9. A vehicular discharge lamp according to claim 7 or 8, **characterized in that** a cover (4) is attached to a lower end portion of the case (6) accommodating the circuit portion (5), and
a drain hole (12) is defined between the cover (4) and the case (6) in the vicinity of the connector portion (8).

10. A vehicular discharge lamp according to claim 7 or 8, **characterized in that** a cover (4) is attached to a lower end portion (6F) of the case (6) accommodating the circuit portion (5), a recess portion (13) is provided on the cover (4), and a protruding portion (14) for positioning that is engaged with the recess portion (13) is provided in the vicinity of the connector portion (8) of the circuit portion (5).
